Europäisches Patentamt

European Patent Office

Office européen des brevets

(19)

(11) Numéro de publication: **0 258 076**
**A1**

(12) **DEMANDE DE BREVET EUROPEEN**

(21) Numéro de dépôt: **87401544.9**

(22) Date de dépôt: **02.07.87**

(51) Int. Cl.⁴: **H 03 B 5/36**

(30) Priorité: **09.07.86 FR 8609975**

(43) Date de publication de la demande:
**02.03.88 Bulletin 88/09**

(84) Etats contractants désignés:
**BE CH DE FR GB IT LI SE**

(71) Demandeur: **COMPAGNIE D'ELECTRONIQUE ET DE PIEZO-ELECTRICITE - C.E.P.E.**
**44, rue de la Glacière**
**F-95100 Argenteuil (FR)**

(72) Inventeur: **Chauvin, Jacques**
**THOMSON-CSF SCPI 19, avenue de Messine**
**F-75008 Paris (FR)**

(74) Mandataire: **Ruellan-Lemonnier, Brigitte et al**
**THOMSON-CSF SCPI 19, avenue de Messine**
**F-75008 Paris (FR)**

Le titre de l'invention a été modifié (Directives relatives à l'examen pratiqué à l'OEB, A-III, 7.3)

(54) **Oscillateur hyperfréquence à quartz.**

(57) Oscillateur à quartz dont la fréquence de résonance est la fréquence fondamentale au mode partiel du quartz et qui permet de maintenir le coefficient de qualité en charge du résonateur (1) à une valeur élevée. Cet oscillateur comporte deux étages amplificateurs ($A_1$, $A_2$) et des quadripôles ($Q_{E1}$, $Q_{S1}$, $Q_{E2}$, $Q_{S2}$) d'adaptation des impédances d'entrée et de sortie des étages amplificateurs ($A_1$, $A_2$) aux autres éléments de la boucle. Un circuit modulateur de phase (4) permet éventuellement de varier la fréquence de l'oscillateur. Le rapport signal sur bruit est de l'ordre de 160dB.
Applications : Télécommunications, radars, bancs de mesure.

FIG_1

EP 0 258 076 A1

## Description

OSCILLATEUR HYPERFREQUENCE A QUARTZ DE TYPE TRANSMISSION EMETTEUR COMMUN A DEUX TRANSISTORS ET A SURTENSION EN CHARGE DETERMINEE.

La présente invention a pour objet un oscillateur à quartz pour très hautes fréquences, typiquement comprises entre 750 MHz et 1,5 GHz.

On connaît des oscillateurs à quartz fonctionnant à très hautes fréquences, c'est-à-dire des fréquences de l'ordre du gigahertz. Ces très hautes fréquences sont obtenues par multiplication de la fréquence de résonance du quartz. Une telle opération dégrade toujours le rapport signal/bruit de l'oscillateur. La dégradation exprimée en décibels est égale à 20 log n si n est le rang de multiplication.

Afin de pallier ces inconvénients, l'invention propose un oscillateur à quartz dont la fréquence de résonance est la fréquence fondamentale au mode partiel du quartz et qui permet de maintenir le coefficient de qualité en charge du résonateur à une valeur élevée. Cet oscillateur est réalisé au moyen de deux transistors et est caractérisé par un rapport signal sur bruit très grand, de l'ordre de 160 dB.

L'invention a donc pour objet un oscillateur hyperfréquence à quartz pouvant fonctionner à des fréquences comprises entre 750 et 1500 MHz et dont la boucle de réaction satisfait aux conditions de Barkhausen, caractérisé en ce que:
- la boucle de réaction comprend au moins les éléments suivants placés en série et dans cet ordre : un premier quadripôle d'adaptation, un premier étage amplificateur, un second quadripôle d'adaptation, un résonateur, un troisième quadripôle d'adaptation, un second étage amplificateur, un quatrième quadripôle d'adaptation et un diviseur de puissance,
- les étages amplificateurs comprennent chacun un transistor monté en émetteur commun,
- les quadripôles d'adaptation permettent d'adapter les impédances d'entrée et de sortie des étages amplificateurs aux autres éléments de la boucle,
- le résonateur est constitué principalement par un quartz,
- le diviseur de puissance permet de prélever le signal de sortie de l'oscillateur vers un circuit d'utilisation.

L'invention sera mieux comprise et d'autres avantages apparaîtront à la lecture de la description qui va suivre, donnée à titre non limitatif, et des figures annexées parmi lesquelles:
- la figure 1 est un schéma synoptique de l'oscillateur selon l'invention,
- la figure 2 est un schéma électrique d'un étage amplificateur à un transistor monté en émetteur commun,
- les figures 3 à 8 sont des schémas électriques de quadripôles adaptateurs d'impédances,
- la figure 9 représente un quartz équipé de sa self de compensation,
- la figure 10 représente un diviseur de puissance,
- la figure 11 est le schéma électrique d'un modulateur de phase commandé en tension,
- la figure 12 est un diagramme donnant l'allure du bruit de phase de l'oscillateur.

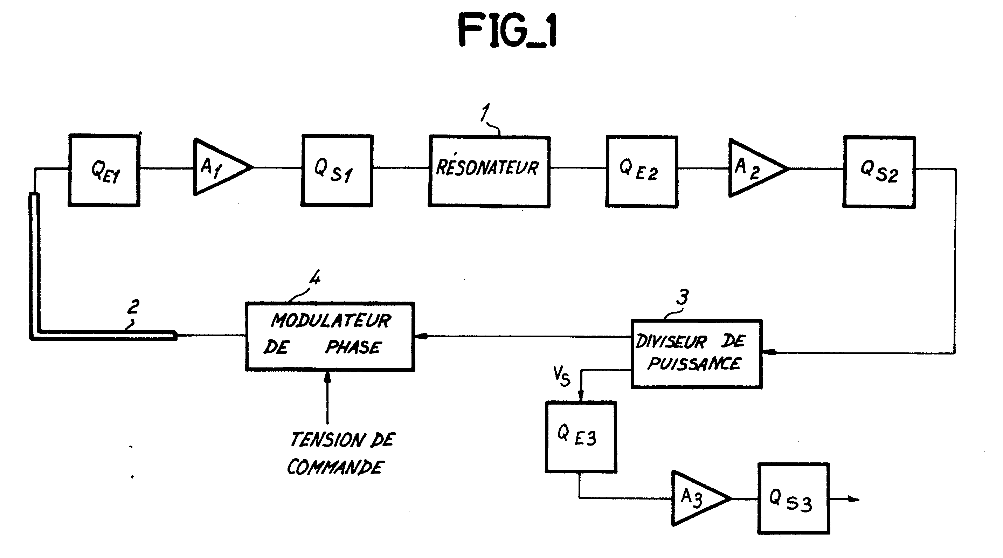

L'oscillateur selon l'invention possède la structure représentée à la figure 1. Ce schéma fonctionnel comprend : deux amplificateurs $A_1$ et $A_2$, quatre quadripôles d'adaptation $Q_{E1}$, $Q_{S1}$, $Q_{E2}$ et $Q_{S2}$, un résonateur 1, une longueur de ligne adaptée 2 pour satisfaire la condition de phase de l'oscillateur, un diviseur de puissance 3 pour prélever le signal de sortie $V_s$, éventuellement un modulateur de phase 4 commandé en tension dans le cas où un accord de fréquence est nécessaire.

L'oscillateur selon l'invention doit satisfaire aux conditions de Barkhausen (gain égal à 1 et différence de phase égale à 2 k$\pi$).

Le quartz utilisé peut être à ondes de surface ou à ondes de volume. Le quartz, dont une fréquence de résonance donnée est choisie comme fréquence de l'oscillateur, est compensé pour cette fréquence par un circuit parallèle comprenant au moins une self. Ce circuit parallèle permet la suppression de la capacité parasite qu'il présente entre ses électrodes. Comme il a été dit plus haut, il est important de maintenir le coefficient de qualité en charge $Q_c$ du résonateur à une valeur élevée. Ce dernier point conditionne directement la qualité spectrale du pilote fo/$2Q_c$ et par conséquent la stabilité temporelle. Le facteur de qualité du quartz dépend des impédances de charge présentes à ses bornes. Si R est la résistance intrinsèque du résonateur, $R_c$ la résistance de charge et $Q_v$ le coefficient de qualité du quartz à vide, il vient:

$$\frac{Q_c}{Q_v} = \frac{R}{R + R_c}$$

Pour que le coefficient de qualité $Q_c$ soit le plus élevé possible, il est important de diminuer $R_c$. La diminution de $R_c$ est limitée par la perte d'insertion $P_I$ que présente le résonateur avec une telle impédance de charge, soit en décibels:

$$P_I = 20 \log \frac{\dfrac{R_c}{2}}{R + \dfrac{R_c}{2}}$$

Par exemple si R = 100$\Omega$ et $R_c$ = 100$\Omega$ (soit une impédance caractéristique de 50$\Omega$) la perte d'insertion est de 9,5 dB et le rapport $Q_c/Q_v$ vaut 0,5. Donc, pour maintenir un coefficient de qualité en charge moitié du coefficient à vide, la perte d'insertion est déjà de 9,5 dB. Cette perte d'insertion doit être compensée par le gain de l'amplificateur. Si l'on considère que la partie amplificatrice compense la perte d'insertion du quartz, la perte d'insertion du diviseur de puissance et qu'elle fournit la marge de gain ε (en dB) utile au démarrage de l'oscillateur, le gain minimal de cette partie amplificatrice doit être, pour l'exemple numérique donné, d'environ 14 dB (9,5 dB pour la perte d'insertion du résonateur + environ 3 dB pour le diviseur de puissance + environ 2 dB pour la marge de gain).

Il est difficile à un oscillateur à un seul transistor de coût modique d'obtenir un tel gain à une fréquence de 1 GHz. L'oscillateur selon l'invention utilise deux transistors pour satisfaire à la condition de gain. Dans ces conditions, en reprenant l'application numérique donnée en exemple et en considérant un gain unitaire de 12 dB par étage amplificateur (ce qui est raisonnable), il restera environ 19 dB pour compenser la perte d'insertion du quartz (24 dB de gain - 3 dB pour le diviseur de puissance- 2 dB pour la marge de gain). Dans ces conditions, de la formule reliant $P_1$ aux impédances R et $R_c$, il vient : $R_c/2 = 0,126$ R. Ainsi, si R = 100Ω, on a $R_c/2 = 12,6$Ω et $Q_c/Q_v = 0,88$. En conséquence, deux transistors permettent d'atteindre un facteur de qualité en charge du quartz très proche du facteur de qualité à vide et de travailler à impédances de charges faibles (environ 0,12R).

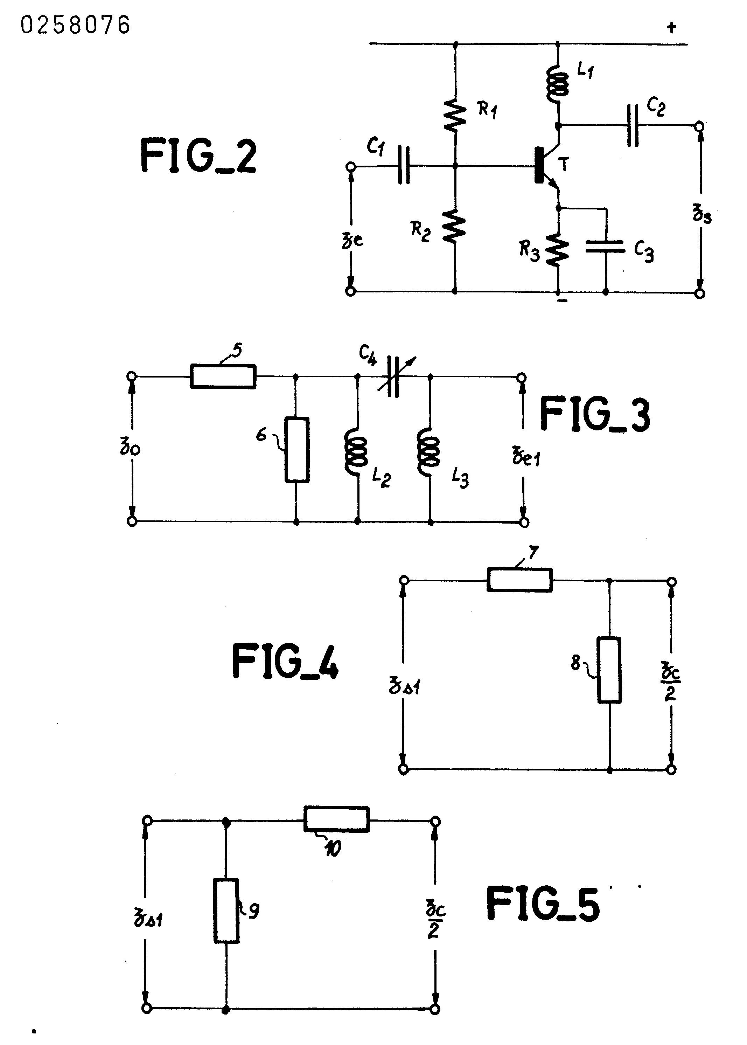

C'est pour ces raisons que l'oscillateur selon l'invention possède deux étages amplificateurs $A_1$ et $A_2$. Chaque amplificateur peut être constitué d'un transistor monté en émetteur commun. Ce montage ayant la propriété d'inverser la phase du signal, la condition de phase ($2k\pi$) est satisfaite. Le schéma électrique de la figure 2 représente un type de montage possible pour ces amplificateurs. Ce montage comprend un transistor T, un pont de résistances $R_1$ et $R_2$ de polarisation, une résistance d'émetteur $R_3$ découplée par une capacité $C_3$, une self d'arrêt $L_1$ et des capacités de liaison $C_1$ et $C_2$. Le montage présente une impédance d'entrée appelée $z_e$ et une impédance de sortie appelée $z_s$.

Les quadripôles $Q_{E1}$ et $Q_{S1}$ sont les quadripôles d'adaptation de l'amplificateur $A_1$, respectivement pour son entrée et sa sortie. L'impédance normalisée étant $z_o$, le quadripôle $Q_{E1}$ permet le passage de l'impédance $z_o$ à l'impédance $z_{e1}$ (impédance d'entrée de l'amplificateur $A_1$) et d'éliminer le gain en basse fréquence grâce à l'incorporation d'un filtre passe-haut. Le schéma électrique de la figure 3 représente un tel quadripôle. Il est formé de deux éléments réactifs 5 et 6 et d'un filtre passe-haut constitué par exemple des selfs $L_2$ et $L_3$ et de la capacité $C_4$ dont la valeur peut être ajustée. Le quadripôle $Q_{S1}$ permet le passage de l'impédance $z_{s1}$ (impédance de sortie de l'amplificateur $A_1$) à l'impédance de charge $z_c/2$. Les figures 4 et 5 représentent des schémas électriques possibles pour ce quadripôle. Les éléments 7, 8, 9 et 10 sont des éléments réactifs.

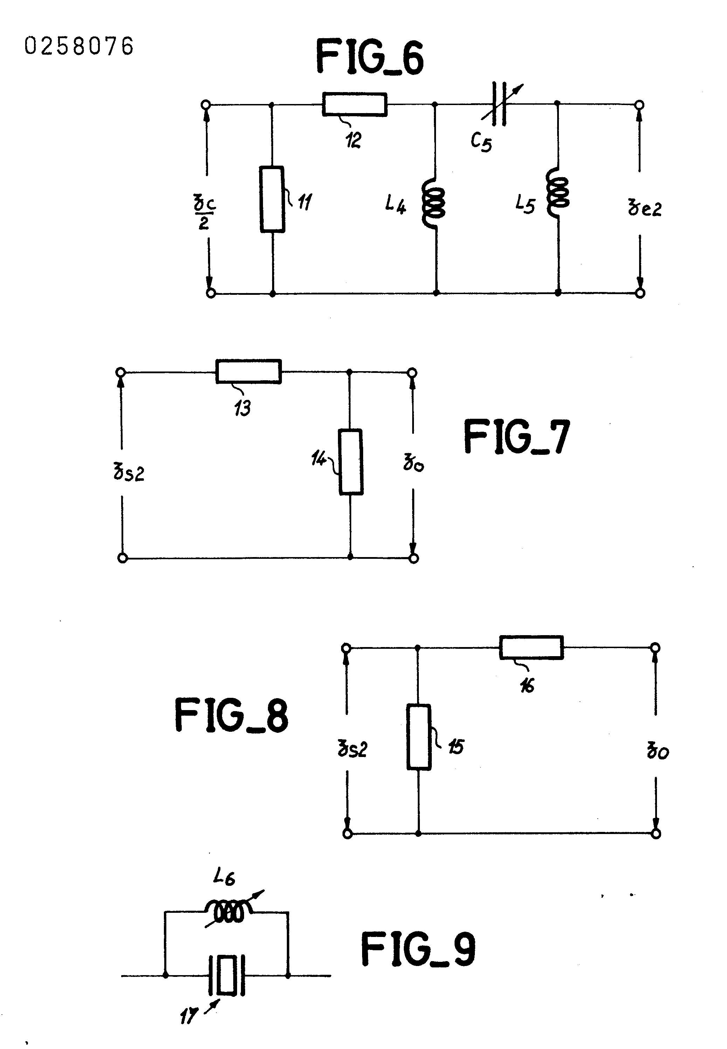

Les quadripôles $Q_{E2}$ et $Q_{S2}$ sont les quadripôles d'adaptation de l'amplificateur $A_2$, respectivement pour son entrée et sa sortie. Le quadripôle $Q_{E2}$ permet le passage de l'impédance de charge $z_c/2$ à l'impédance $z_{e2}$ (impédance d'entrée de l'amplificateur $A_2$) et d'éliminer le gain en basse fréquence grâce à l'incorporation d'un filtre passe-haut. Le schéma électrique de la figure 6 représente un tel quadripôle. Il est formé de deux éléments réactifs 11 et 12 et d'un filtre passe-haut constitué par exemple des selfs $L_4$ et $L_5$ et de la capacité $C_5$ dont la valeur peut être ajustée. Le quadripôle $Q_{S2}$ permet le passage de l'impédance $z_{s2}$ (impédance de sortie de l'amplificateur $A_2$) à l'impédance $z_o$. Les figures 7 et 8 représentent des schémas électriques possibles pour ce quadripôle. Les éléments 13, 14, 15 et 16 sont des éléments réactifs.

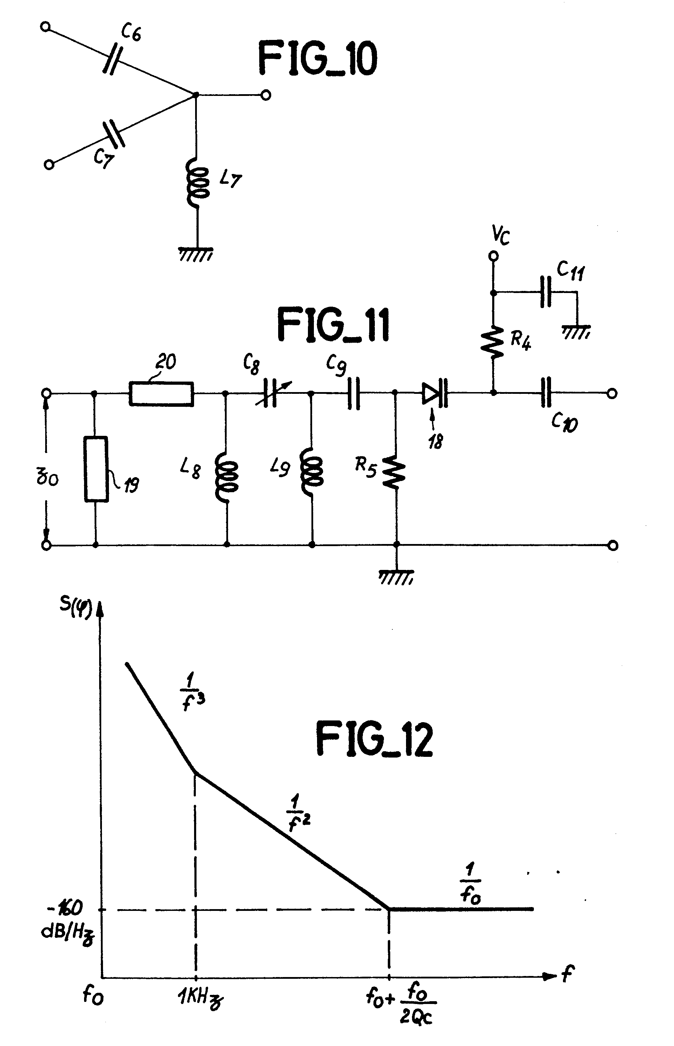

Le quartz hyperfréquence constituant le résonateur est de préférence monté avec un circuit en parallèle comprenant au moins une self comme le montre la figure 9. La self $L_6$ est réglée de façon à former un circuit bouchon avec la capacité parasite du quartz 17 à la fréquence de travail. L'effet de shunt de cette capacité parasite est ainsi éliminé. Ce montage est spécifique au quartz à ondes de volume, le quartz à ondes de surface ne présentant pas cette capacité parasite.

Le diviseur de puissance peut être réalisé en composants discrets suivant la technique dite de Wilkinson. Il peut être symétrique ou asymétrique. Un exemple de réalisation est représenté à la figure 10 et comprend la self $L_7$ et les deux capacités $C_6$ et $C_7$. Il permet de prélever un signal $V_s$ dans la boucle de réaction pour son utilisation par exemple dans un étage de sortie. L'entrée et les sorties du diviseur sont adaptées à l'impédance $z_o$. Cet étage de sortie peut comprendre un amplificateur $A_3$ précédé d'un quadripôle $Q_{E3}$ permettant d'adapter l'impédance de sortie du diviseur de puissance 3 et suivi d'un quadripôle $Q_{S3}$ permettant d'adapter l'impédance de sortie de cet amplificateur à l'impédance caractéristique $z_o$.

Le rôle du modulateur de phase est de créer un déphasage dans la boucle en fonction d'une tension de commande, toute variation de phase s'accompagnant d'une variation de fréquence liée au facteur de qualité en charge du quartz. La variation de phase devra être suffisante pour obtenir la déviation en fréquence souhaitée mais relativement faible pour ne pas remettre en cause les conditions d'oscillation. Une variation de phase de 30° est un bon ordre de grandeur.

La figure 11 représente un schéma électrique d'un modulateur de phase particulièrement bien adapté à l'invention. Il est essentiellement constitué d'un varactor 18 adapté à la fréquence de travail ainsi que d'un filtre passe-haut constitué par exemple des selfs $L_8$ et $L_9$ et de la capacité ajustable $C_8$. Ce filtre passe-haut facilite l'adaptation d'impédance. Les éléments réactifs 19 et 20 permettent d'adapter ce côté du modulateur à l'impédance $z_o$. La polarisation du varactor 18 est réalisée par les résistance $R_4$ et $R_5$. Les capacités $C_9$ et $C_{10}$ sont des capacités de liaison. La capacité $C_{11}$ est une capacité de découplage. Le modulateur de phase est relié par l'intermédiaire de la capacité $C_{10}$ à la ligne adaptée référencée 2 à la figure 1.

La ligne d'impédance caractéristique $z_o$ est de longueur telle que la condition de phase soit remplie dans la boucle. Si $\lambda$ m est la longueur d'onde dans une telle ligne à la fréquence considérée une longueur L de ligne introduira un déphasage exprimé en degrés égal à $(L \times 360)/\lambda m$. Si le déphasage n'est pas nécessaire, la ligne de phase peut être supprimée.

Le modulateur de phase et la ligne de phase peuvent être placés en un endroit quelconque de la boucle à condition que les adaptations d'impédance soient respectées. Dans le cas où la fréquence doit être fixe, le modulateur de phase peut être supprimé.

La figure 12 est un diagramme illustrant une application numérique de l'oscillateur selon l'invention. Ce diagramme donne l'allure du bruit de phase $S(\varphi)$ exprimé en décibels par hertz en fonction de la fréquence de Fourier f en échelle logarithmique. Le spectre est donné pour une fréquence centrale $f_o$ de 1 GHz. Le résonateur à quartz possédant un facteur de qualité à vide de 40 000 et une résistance de 250$\Omega$, l'impédance de charge $z_c/2$ sera de 31,5$\Omega$ et le facteur de qualité en charge $Q_c$ sera d'environ 35 500 d'après les formules données plus haut. Le spectre de phase comprend une pente en $1/f^3$ caractéristique du bruit de scintillation (ou bruit Flicker), une pente en $1/f^2$ caractéristique du résonateur et comprise entre des fréquences d'environ $f_o$ + 1 kHz et $f_o$ + 14 kHz, et une droite horizontale à - 160 dB/Hz caractéristique du bruit de fond de l'oscillateur.

L'oscillateur selon l'invention possède une qualité spectrale remarquable. Il convient particulièrement bien au domaine métrologique dont les applications nécessitent des oscillateurs locaux à faible bruit dans une bande de fréquence allant de 750 MHz à 1,5 GHz. Il permet en outre d'éviter des multiplications de fréquence néfastes au palier de bruit. Il procure une économie d'énergie et de volume.

Les télécommunications, les radars, les bancs de mesure constituent des domaines d'applications privilégiés de ces oscillateurs.

## Revendications

1. Oscillateur hyperfréquence à quartz pouvant fonctionner à des fréquences comprises entre 750 et 1500 MHz et dont la boucle de réaction satisfait aux conditions de Barkhausen, caractérisé en ce que:
- la boucle de réaction comprend au moins les éléments suivants placés en série et dans cet ordre : un premier quadripôle d'adaptation ($Q_{E1}$), un premier étage amplificateur ($A_1$) un second quadripôle d'adaptation ($Q_{S1}$), un résonateur (1), un troisième quadripôle d'adaptation ($Q_{E2}$), un second étage amplificateur ($A_2$), un quatrième quadripôle d'adaptation ($Q_{S2}$) et un diviseur de puissance (3),
- les étages amplificateurs ($A_1$, $A_2$) comprennent chacun un transistor (T) monté en émetteur commun,
- les quadripôles d'adaptation permettent d'adapter les impédances d'entrée et de sortie des étages amplificateurs aux autres éléments de la boucle,
- le résonateur (1) est constitué principalement par un quartz,

- le diviseur de puissance (3) permet de prélever le signal de sortie ($V_s$) de l'oscillateur vers un circuit d'utilisation.

2. Oscillateur selon la revendication 1, caractérisé en ce que le premier quadripôle d'adaptation ($Q_{E1}$) comprend un filtre passe-haut ($L_2$, $L_3$, $C_4$).

3. Oscillateur selon l'une des revendications 1 ou 2, caractérisé en ce que le troisième quadripôle d'adaptation ($Q_{E2}$) comprend un filtre passe-haut ($L_4$, $L_5$, $C_5$).

4. Oscillateur selon l'une quelconque des revendications 1 à 3, caractérisé en ce que la capacité parasite du quartz (17) est compensée, à la fréquence de travail, par un circuit comprenant au moins une self ($L_6$).

5. Oscillateur selon l'une quelconque des revendications 1 à 4, caractérisé en ce que le diviseur de puissance (3) est de type Wilkinson.

6. Oscillateur selon l'une quelconque des revendications 1 à 5, caractérisé en ce que la boucle de réaction comprend également une ligne de phase (2) dont la longueur est déterminée de façon à satisfaire à la condition de phase.

7. Oscillateur selon l'une quelconque des revendications 1 à 6, caractérisé en ce que la boucle de réaction comprend en outre un modulateur de phase (4) commandé en tension ($V_c$).

8. Oscillateur selon la revendication 7, caractérisé en ce que la modulation de phase est obtenue par l'intermédiaire d'un varactor (18) soumis à la tension de commande ($V_c$).

# FIG_1

0258076

**FIG_2**

**FIG_3**

**FIG_4**

**FIG_5**

0258076

**FIG_6**

**FIG_7**

**FIG_8**

**FIG_9**

0258076

**FIG_10**

**FIG_11**

**FIG_12**

## Office européen des brevets

# RAPPORT DE RECHERCHE EUROPEENNE

Numéro de la demande

EP 87 40 1544

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 139 583 (C.E.P.E.) <br> * Page 3, ligne 20 - page 11, ligne 33; figures 1-11 * | 1-8 | H 03 B 5/36 |
| | --- | | |
| Y | MICROWAVE JOURNAL, vol. 25, no. 2, février 1982, pages 91-93, Dedham, Massachusetts, US; S. NEYLON: "Hybrid saw oscillators" * En entier * | 1-8 | |
| | --- | | |
| A | US-A-4 139 826 (B.M. PRADAL) <br> * Colonne 1, ligne 52 - colonne 2, ligne 42; figure * | 1,7,8 | |
| | --- | | |
| A | GB-A-1 144 459 (STANDARD TELEPHONES AND CABLES) <br> * Page 2, lignes 37-110; figures 1,2 * | 2 | DOMAINES TECHNIQUES RECHERCHES (Int. Cl.4) <br><br> H 03 B 5/00 |
| | ----- | | |

Le présent rapport de recherche a été établi pour toutes les revendications

| Lieu de la recherche | Date d'achèvement de la recherche | Examinateur |
|---|---|---|
| LA HAYE | 07-10-1987 | BALBINOT H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82